# EUROPEAN PATENT APPLICATION

(11) **EP 1 580 815 A2**
(43) Date of publication of application: **28.09.2005**
(21) Application number: 05445015.0
(22) Date of filing: 17.03.2005
(51) Int. Cl.: H01L 29/94, H01L 29/93, H01L 21/329, H01L 21/02, H01L 27/06

(54) **Integrated switch device**

(30) Priority: 23.03.2004 SE 0400739
(71) Applicant: Infineon Technologies AG, 81669 München (DE)
(72) Inventor: Litwin, Andrej, 182 35 Danderyd (SE)
(74) Representative: Fritzon, Rolf

(57) **Abstract**

A monolithically integrated MOS varactor switch device comprises an SOI (Silicon-On-Insulator) substrate (11), a gate on top of the SOI substrate, contact regions (17, 18) in the substrate at each side of the gate, and a well region (13) arranged beneath the gate, wherein the gate includes a gate semiconductor layer region (15) on top of a gate insulation layer region (14), and the well region interconnects the contact regions (17, 18). According to the invention the contact regions (17, 18) are laterally separated from the gate, preferably by a distance of at least 10 nm. The contact regions (17, 18) as well as the well region (13) are doped to the same doping type, and the SOI substrate is advantageously thinner than about 200 nm to allow full depletion of the silicon during use of the MOS varactor switch device.

## Description

### TECHNICAL FIELD OF THE INVENTION

The present invention generally relates to the field of integrated circuit technology, and more specifically the invention relates to a monolithically integrated MOS varactor switch device and to a method of fabricating such a device.

### DESCRIPTION OF RELATED ART AND BACKGROUND OF THE INVENTION

Great efforts have been made to meet the requirements of performance and compactness of mobile phones and other portable radio communication terminal devices.

As there is a continuous demand of such devices having even smaller sizes, the requirements of better performance, more functions and services increase. As a result, an increased number of components have to fit in a decreasing volume or area of the devices.

Many of the radio communication terminal devices are provided with some kind of antenna switch for e.g. switching at least one antenna between transmitting and receiving modes. Integrated antenna switches have been proposed to reduce the number of several bulky discrete components such as inductors, capacitors, filters and PIN diodes. The switching element in such integrated circuits could be a PIN diode, as disclosed in WO 99/52172, a varactor coupled MOS transistor as disclosed in EP 0 978 949 A1, and in Song, S.-S. and Shin, H., "An RF model of the Accumulation-Mode MOS Varactor Valid in Both Accumulation and Depletion Regions, IEEE Transactions on Electron Devices, Vol. 50, No. 9, September 2003, pp. 1997-1999, or even a SOI MOS transistor as disclosed in Tinella, C., Fournier, J.M., Belot, D., and Knopik, V., "A high-performance CMOS-SOI antenna switch for the 2.5-5-GHz band", Solid-State Circuits, IEEE Journal of, Volume: 38, Issue: 7, July 2003, pp. 1279-1283.

For lowest system cost with the increased complexity of the electronic systems, even the analogue parts including frequency synthesis are preferred to be integrated in CMOS integrated circuits without any changes to the CMOS process.

### SUMMARY OF THE INVENTION

PIN diodes mentioned above are readily available in bipolar or BiCMOS processes. However, in CMOS processes, which are preferred for more and more of the RF circuits, such PIN diodes are difficult to fabricate while maintaining good signal properties.

MOS varactors e.g. as disclosed by P. Andreani and S. Mattisson, "On the Use of MOS Varactors in RF VCO's", IEEE Journal of Solid-State Circuits, Vol. 35, No. 6, June 2000, pp. 905, and by A. Litwin and S. Mattisson in U.S. Patent No. 6,100,770, and coupled as the varactors described in EP 0 978 949 A1, have a limited ratio between minimum and maximum capacitance. This will in turn cause either insufficient isolation or too high impedance in the signal path, depending on the size of the varactor.

Accordingly, it is an object of the present invention to provide a monolithically integrated MOS varactor switch device, which provides for a high capacitance ratio between accumulation and depletion modes.

It is in this respect a particular object of the invention to provide such a varactor switch device, which has a larger capacitance ratio than prior art bulk devices.

It is a further object of the invention to provide such a varactor switch device, which has a maximum capacitance set by the thickness of the gate oxide, and a minimum capacitance close to zero.

It is yet a further object of the present invention to provide such a varactor switch device, which when being fabricated in a known CMOS or BiCMOS SOI process does not need any additional process steps.

Still further, it is an object of the invention to provide a radio communication terminal device comprising a monolithically integrated MOS varactor switch device, which fulfills the above-identified objects.

Yet further, it is an object of the present invention to provide an antenna device comprising an antenna capable of being switched, and a monolithically integrated MOS varactor switch device provided for switching the antenna, which varactor switch device fulfills the above-identified objects.

Still further, it is an object of the invention to provide a method of fabricating the monolithically integrated MOS varactor switch device.

These objects are according to the present invention attained by monolithically integrated MOS varactor switch devices, radio communication terminal devices, antenna devices, and methods as claimed in the appended patent claims.

According to a first aspect of the present invention, there is provided a monolithically integrated MOS varactor switch device comprising a gate on top of an SOI (silicon-on-insulator) substrate, contact regions in the SOI substrate at each side of the gate, and a well region beneath the gate, which interconnects the contact regions, wherein the contact regions are separated, preferably by a distance of at least 10 nm, from the gate in a horizontal or lateral plane, i.e. there is at least 10 nm between each of the contact regions and the gate as seen from above. Advantageously, the contact regions and the well region are doped to the same doping type, e.g., n type.

The well region is occupying the complete thickness of the silicon-on-insulator, and is thus delimited downwards by the insulator of the SOI substrate. Preferably, the well region has a selected dopant concentration and a thickness of less than 200 nm to provide for fully depleted SOI-fabricated devices.

The MOS varactor switch device of the invention has a minimum overlap capacitance between the gate and the contact regions. The varactor is designed so that the well region under the gate can be fully depleted, while leaving effectively the fringe capacitance between the gate and the contact regions as the sole gate-to-silicon capacitance.

The inventive SOI-based MOS varactor switch device has a very large capacitance ratio between accumulation and depletion modes compared to bulk devices. In accumulation mode, the maximum capacitance is defined by the gate oxide thickness. In depletion mode, the vertical capacitance is almost zero since the buried oxide is typically two orders of magnitude thicker than the gate oxide. Thus, a varactor switch device having a very high minimum-to-maximum capacitance ratio is obtained and effective microwave switching is enabled.

According to a second aspect of the present invention, there is provided a radio communication terminal device comprising the above-described monolithically integrated MOS varactor switch device.

According to a third aspect of the present invention, there is provided an antenna device capable of being switched, and the above-described monolithically integrated MOS varactor switch device provided for switching the antenna device.

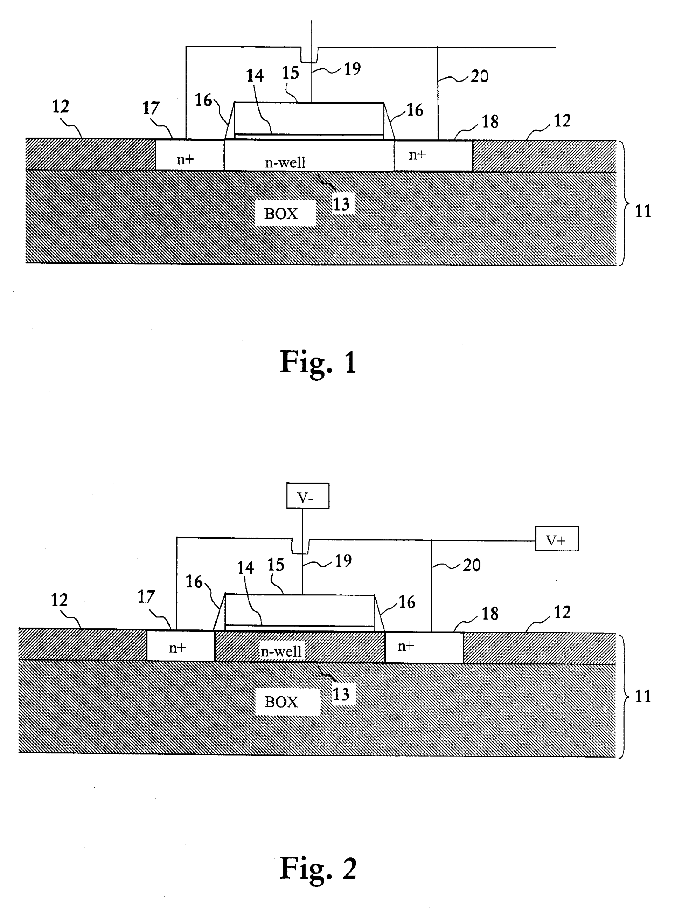

Further characteristics of the invention and advantages thereof will be evident from the detailed description of preferred embodiments of the present invention given hereinafter and the accompanying Figs. 1-2, which are given by way of illustration only, and are thus not limitative of the present invention.

### BRIEF DESCRIPTION OF THE DRAWINGS

Figs. 1 and 2 are highly enlarged cross-sectional views of a portion of a semiconductor structure including a partially processed MOS varactor switch device according to a preferred embodiment of the present invention.
Figs. 3 and 4 illustrate schematically a radio communication terminal device and an antenna device, respectively, according to further preferred embodiments of the present invention.

### DETAILED DESCRIPTION OF PREFERRED EMBODIMENTS

A semiconductor structure is shown in Fig. 1 in cross section. A common SOI structure substrate 11 comprises a buried silicon oxide layer BOX and a monocrystalline silicon layer thereupon. The monocrystalline silicon layer is a thin layer having advantageously a thickness of less than about 200 nm in order to be capable of fabricating fully depleted or partially depleted MOS devices.

Shallow trench or other isolation regions 12 are formed in this monocrystalline silicon layer of the SOI substrate 11 to surround the inventive MOS varactor switch device. The isolation regions 12, which preferably are formed by masking and etching, are filled with insulating material. Due to the small thickness of the monocrystalline silicon layer, the isolation regions 12 reach down to the buried silicon oxide layer BOX.

In the monocrystalline silicon layer of the SOI substrate 11, an n-well region 13 is formed by means of doping of the monocrystalline silicon layer to e.g. n-type. On top of the n-well region 13, a gate, including a gate semiconductor layer region 15 on top of a gate insulation layer region 14, is formed.

On opposite sides of the n-well region 13, heavily n-type doped contact regions 17, 18 are formed in the monocrystalline silicon layer of the SOI substrate 11. These contact regions 17, 18 correspond to source and drain regions of a MOS transistor.

According to the present invention, the n-well region 13 extends laterally well beyond the gate at least in the directions towards the contact regions 17, 18, and as a result the contact regions 17, 18 are laterally separated from the gate, preferably by a distance of at least 10 nm.

On the other hand, the lateral separation between the contact regions 17, 18 and the gate should not be to large since the resistance will be too high and thus the Q-value will be too low. The high frequency properties would deteriorate. The separation should thus not be larger than about 100 nm.

Insulating outside sidewall spacers 16 are formed on top of the SOI substrate 11 on opposite sides of the gate to inter alia provide isolation between the gate and the contact regions 17, 18.

A schematically shown connector 19 connected to the gate, and a likewise schematically shown connector 20 short-circuiting the contact regions 17, 18 are also illustrated in Fig. 1. The contact regions 17, 18 are short circuited either by external metal connections or by being in physical contact at least at one of the ends of the gate.

The varactor can be fabricated using process steps common to a CMOS process on SOI. The design is similar to an NMOS transistor except for that the p-well is replaced by an n-well and the LDD (Lightly Doped Drain) extensions are blocked out during the implantation step to provide for the lateral separation between the gate and the contact regions 17, 18.

The insulating outside sidewall spacers (16) formed on top of the SOI substrate (11) on opposite sides of the gate provides for the lateral separation between the contact regions 17, 18 and the gate since the contact regions 17, 18 are formed by means of implantation typically without using a photo mask. Thus, the lateral separation is set by the width of the insulating outside sidewall spacers 16.

The thickness and the doping level of the monocrystalline silicon layer are chosen to allow to fully deplete the n-well under the gate, when a predetermined positive voltage V+ is applied to the contact regions 17, 18, and a negative voltage V-is applied to the gate. The thickness is preferably between 30 and 200 nm. The semiconductor structure cross section in a fully depleted condition is shown in Fig. 2.

A very low parasitic resistance is achieved by keeping the gate length of the transistor short, and by keeping the gate width relatively narrow. A large capacitance is then formed by means of connecting a plurality of varactors in parallel to get the desired total capacitance, even if the total area of the varactor will increase by doing so.

There are many possible manners to realize a MOS varactor switch device using CMOS process steps. In an alternative preferred embodiment of the present invention, the doping type in the varactor is changed from n- to p-type to achieve a p-type accumulation varactor device.

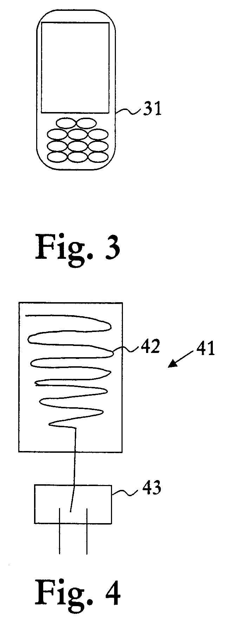

A preferred embodiment of a radio communication terminal device 31 comprising the monolithically integrated MOS varactor switch device of Figs. 1-2 is schematically illustrated in Fig. 3. The monolithically integrated MOS varactor switch device of Figs. 1-2 is advantageously provided for switching an antenna of the radio communication terminal device 31.

A preferred embodiment of an antenna device 41 comprising an antenna 42 capable of being switched and the monolithically integrated MOS varactor switch device of Figs. 1-2 provided for switching the antenna device is schematically illustrated in Fig. 4, wherein the varactor switch device is denoted by 43. In one version of the embodiment of Fig. 4 the monolithically integrated MOS varactor switch device of Figs. 1-2 is provided for switching the antenna between transmitting and receiving modes.

It shall be appreciated that while the MOS varactor switch device of present invention is primarily intended for radio frequency antenna devices and radio communication terminal devices, it may as well be useful for other applications in silicon or other semiconductor integrated circuits.

## Claims

1. A monolithically integrated MOS varactor switch device comprising:
- an SOI (Silicon-On-Insulator) substrate (11),
- a gate on top of said SOI substrate, said gate including a gate semiconductor layer region (15) on top of a gate insulation layer region (14),
- contact regions (17, 18) in said substrate at each side of said gate,
- a well region (13) arranged beneath said gate, said well region interconnecting said contact regions, **characterized in that**
- said contact regions (17, 18) and said well region (13) are doped to a first doping type, and
- said contact regions (17, 18) are laterally separated from said gate.

2. The MOS varactor switch device of claim 2, wherein said contact regions (17, 18) are laterally separated from said gate by a distance of at least 10 nm, preferably by a distance between about 10 nm and about 100 nm, and more preferably by a distance between about between 10 nm and about 80 nm.

3. The MOS varactor switch device of claims 1 or 2, wherein said contact regions (17, 18) are heavier doped than said well region (13).

4. The MOS varactor switch device of any of claims 1-3, wherein said well region (13) is delimited downwards by an insulator (BOX), and has a thickness of less than 200 nm.

5. The MOS varactor switch device of claim 4, wherein said well region (13) has a thickness and dopant concentration so as to allow full depletion of said well region (13) when said contact regions (17, 18) are held at a predetermined electric potential.

6. The MOS varactor switch device of any of claims 1-5, wherein said contact regions (17, 18) are interconnected (20).

7. The MOS varactor switch device of any of claims 1-6, comprising a plurality of gates connected in parallel, and a plurality of said contact regions (17, 18) connected in parallel.

8. A radio communication terminal device (31) comprising the monolithically integrated MOS varactor switch device of any of claims 1-7.

9. An antenna device (41) comprising an antenna (42) capable of being switched, and the monolithically integrated MOS varactor switch device (43) of any of claims 1-7 provided for switching said antenna device.

10. The antenna device of claim 9, wherein said monolithically integrated MOS varactor switch device is provided for switching said antenna between transmitting and receiving modes.

11. A radio communication terminal device (31) comprising the antenna device (41) of claim 9 or 10.

12. A method of fabricating a monolithically integrated circuit including a MOS varactor switch device comprising the steps of:
- providing an SOI (Silicon-On-Insulator) substrate (11),
- forming a well region (13) doped to a first doping type in said SOI substrate,
- forming a gate on top of said well region, said gate including a gate semiconductor layer region (15) on top of a gate insulation layer region (14),
- forming contact regions (17, 18) in said substrate at each side of said gate so that said well region interconnects said contact regions, **characterized in that**:
- said contact regions (17, 18) are formed laterally separated from said gate by means of doping said substrate to the first doping type.

13. The method of claim 12, wherein
- said monolithically integrated circuit comprises MOS transistors,
- the drains of said MOS transistors are LDD (Lightly Doped Drain) implanted, and
- said MOS varactor switch device is blocked during the LDD implantation to provide for the lateral separation between said contact regions (17, 18) and said gate.

14. The method of claim 12 or 13, wherein
- insulating outside sidewall spacers (16) are formed on top of the SOI substrate (11) on opposite sides of the gate,
- the contact regions (17, 18) are formed by means of implantation, and
- the lateral separation between said contact regions (17, 18) and said gate is set by the width of said insulating outside sidewall spacers (16).

15. The method of claim 14, wherein the width of said insulating outside sidewall spacers (16), and thus the lateral separation between said contact regions (17, 18) and said gate, is selected to be between about 10 nm and about 100 nm, and preferably between about 10 nm and about 80 nm.
